# DEMANDE DE BREVET EUROPEEN

(11) **EP 4 391 076 A1**
(43) Date de publication de la demande: **26.06.2024**
(21) Numéro de dépôt: 23218290.7
(22) Date de dépôt: 19.12.2023
(51) Int. Cl.: H01L 29/423, H01L 29/66, B82Y 10/00

(54) **DISPOSITIF QUANTIQUE DESTINÉ À FORMER UNE MATRICE DE BOITES QUANTIQUES ET PROCÉDÉ DE FABRICATION ASSOCIÉ**

(30) Priorité: 20.12.2022 FR 2214000
(71) Demandeur: Commissariat à l'énergie atomique et aux énergies alternatives, 75015 Paris (FR)
(72) Inventeur: BERTRAND, Benoit, 38054 GRENOBLE CEDEX 09 (FR); BEDECARRATS, THOMAS, 38054 GRENOBLE CEDEX 09 (FR); NIEBOJEWSKI, Heimanu, 38054 GRENOBLE CEDEX 09 (FR)
(74) Mandataire: Cabinet Camus Lebkiri

(57) **Abrégé**

Un aspect de l'invention concerne une dispositif quantique (DQ) configuré pour pouvoir former une matrice de boites quantiques (QD), le dispositif (DQ) comprenant pour cela : une couche active (CA) réalisée dans un matériau semi-conducteur ; une pluralité de premières grilles (G1) disposées selon une pluralité de lignes (LI) ; une pluralité de deuxièmes grilles (G2) disposées selon un pluralité de colonnes (CO) perpendiculaires aux lignes (LI) de la pluralité de lignes (LI) ; une pluralité de troisièmes grilles (G3), chaque troisième grille (G3) de la pluralité de troisièmes grilles (G3) étant disposée à l'intersection d'une ligne de la pluralité de lignes (LI) et d'une colonne de la pluralité de colonnes (CO), chaque troisième grille (G3) étant séparée des troisièmes grilles (G3) les plus proches, sur une ligne (LI) par une première grille (G1) et sur une colonne (CO) par une deuxième grilles (G2) ; une pluralité de quatrièmes grilles (G4), chaque quatrième grille (G4) étant disposée entre deux deuxièmes grilles (G2) selon les lignes (LI) et entre deux première grille (G1) selon les colonnes (CO). Les troisièmes grilles (G3) sont configurées pour contrôler le potentiel chimique d'une portion de la couche active (CA) se trouvant à l'aplomb de ladite troisième grille.

## Description

### DOMAINE TECHNIQUE DE L'INVENTION

Le domaine technique de l'invention est celui de l'informatique quantique.

La présente invention concerne un dispositif semi-conducteur comprenant des moyens pour former une matrice de boites quantiques et en particulier un dispositif permettant de contrôler le potentiel chimique au sein de chaque boite quantique et le couplage entre des boites quantiques adjacentes, ce contrôle se faisant de manière locale, tout en garantissant l'absence de particule chargée en dehors des boites quantiques. La présente invention concerne également un procédé de fabrication permettant d'obtenir un tel dispositif.

### ARRIÈRE-PLAN TECHNOLOGIQUE DE L'INVENTION

Dans le domaine de l'informatique quantique, il est connu d'utiliser des boites quantiques dans lesquelles une ou plusieurs particules chargées peuvent être piégées pour être manipulées. Pour cela, le confinement des particules chargées doit se faire dans les trois dimensions de l'espace. Dans l'état de la technique, un tel confinement peut être obtenu de deux manières (qui peuvent être utilisée en combinaison) : de manière structurelle (par alternance de matériaux selon au moins une dimension de l'espace) et/ou de manière électrostatique par l'application d'un potentiel sur une portion de matériau conducteur (par exemple à l'aide d'une électrode de grille). De manière générale, les boites quantiques sont agencées sous la forme d'une matrice de boites quantiques ce qui permet une meilleure inter-connectivité entre boites quantiques et donc, par exemple, une exécution plus efficace des algorithmes de correction d'erreurs quantiques (voir par exemple Flowler, Phys. Rev. A, 2012).

Une matrice de boites quantiques a par exemple été proposée dans le document Li et al., Science, 2018. Dans ce document, les auteurs proposent une structure comprenant trois niveaux de grilles : selon les lignes, les colonnes et les diagonales de la matrice de boites quantiques, ces niveaux de grille permettant de contrôler le potentiel chimique dans chaque boite quantique ainsi que les barrières de potentiel (ou couplage tunnel) entre les boites quantiques adjacentes. En revanche, le dispositif ne permet pas de contrôler totalement la position des particules chargées et, en particulier, d'interdire la présence de ces dernières en dehors des boites quantiques, c'est à dire entre les lignes et les colonnes de la matrice de boites quantiques. De plus, l'utilisation de trois niveaux grilles implique un écrantage des niveaux de grille supérieurs par les niveaux de grille inférieurs ce qui entraîne une forte disparité entre les différents niveaux de grille (la grille de premier niveau apparaît continue alors que les grilles de deuxième et troisième niveau prennent la forme d'une ligne pointillée).

Une autre architecture a été proposée dans le document FR3066297. Dans cette dernière, la couche active de la matrice de boites quantiques est structurée de sorte à interdire la présence de particules chargées en dehors des boites quantiques, c'est à dire entre les lignes et les colonnes de la matrice de boites quantiques. Par ailleurs, le dispositif proposé comprend également une pluralité de grilles permettant de contrôler les barrières de potentiel entre les boites quantiques adjacentes de la matrice de boites quantiques. En revanche, compte tenu de la difficulté d'implantation, le dispositif proposé ne comprend pas de grille permettant un contrôle local du potentiel chimique au sein de chaque boite quantique. En outre, le contrôle des grilles est réalisé à l'aide de vias ce qui permet une bonne homogénéité entre les grilles, mais impose en revanche des contraintes très strictes en termes d'alignement relatif des différents niveaux de grilles, et donc un procédé de fabrication complexe à mettre en oeuvre rendant.

Il existe donc un besoin d'un dispositif permettant d'obtenir à la fois un contrôle électrostatique homogène, un contrôle local (c'est à dire par une grille située au-dessus de l'élément à contrôler) du potentiel chimique au sein de chaque boite quantique et un moyen de garantir l'absence de charge électrique entre les lignes et les colonnes de la matrice. Il existe en outre un besoin d'un procédé permettant d'obtenir un tel dispositif sans imposer des contraintes très strictes d'alignement lors de la fabrication.

### RÉSUMÉ DE L'INVENTION

L'invention offre une solution aux problèmes évoqués précédemment, en proposant un dispositif permettent d'obtenir à la fois un contrôle électrostatique homogène, le contrôle local (c'est à dire par une grille située directement au dessus de l'élément à contrôler) du potentiel chimique au sein de chaque boite quantique et un moyen de garantir l'absence de particule chargée entre les lignes et les colonnes de la matrice. Elle y parvient grâce notamment à la mise en oeuvre d'un procédé permettant de réaliser les grilles ainsi que les motifs entre les lignes et les colonnes de la matrice de boites quantiques de manière auto-alignée et sur un seul niveau de lithographie.

Pour cela, un premier aspect de l'invention concerne un dispositif quantique configuré pour former une matrice de boites quantiques, le dispositif comprenant :
- Une couche active réalisée dans un matériau semi-conducteur ;
- Une pluralité de premières grilles disposées selon une pluralité de lignes ;
- Une pluralité de deuxièmes grilles disposées selon un pluralité de colonnes perpendiculaires aux lignes de la pluralité de lignes ;
- Une pluralité de troisièmes grilles, chaque troisième grille de la pluralité de troisièmes grilles étant disposée à l'intersection d'une ligne de la pluralité de lignes et d'une colonne de la pluralité de colonnes, chaque troisième grille étant séparée des troisièmes grilles les plus proches, sur une ligne par une première grille et sur une colonne par une deuxième grilles ;
- Une pluralité de quatrièmes grilles, chaque quatrième grille étant disposée entre deux deuxièmes grilles selon les lignes et entre deux première grille selon les colonnes.

Grâce au dispositif selon l'invention, il est possible d'obtenir un contrôle électrostatique homogène permettant notamment de garantir l'absence de charge électrique entre les lignes et les colonnes de la matrice, un contrôle local (c'est à dire par une grille située directement au-dessus de l'élément à contrôler) du potentiel chimique au sein de chaque boite quantique. Plus particulièrement, dans le dispositif selon l'invention, une boite quantique pourra être formée au-dessous de chaque troisième grille de sorte à former une matrice de boites quantiques. En effet, chaque première grille de la pluralité de premières grilles permet, lorsqu'on lui applique un potentiel électrique, de modifier la barrière de potentiel séparant deux parties de la couche active situées sous deux troisièmes grilles adjacentes selon les lignes. De même, chaque deuxième grille de la pluralité de deuxièmes grilles permet, lorsqu'on lui applique un potentiel électrique, de modifier la barrière de potentiel séparant deux parties de la couche active situées sous deux troisièmes grilles adjacentes selon les colonnes. De plus, chaque quatrième grille de la pluralité de quatrièmes grilles permet, lorsqu'on lui applique un potentiel électrique, de former une barrière de potentiel garantissant l'absence de particule chargé au-dessous de ladite grille, c'est-à-dire en dire entre les lignes et les colonnes de la matrice. En outre, les premières grilles, les deuxièmes grilles et les quatrièmes grilles permettent d'effectuer cette modification de manière locale, ces dernières n'étant pas écrantée par une couche conductrice (autrement dit, il n'y a pas de couche conductrice entre l'oxyde des premières grilles, des deuxièmes grilles et des quatrièmes grilles et la couche active). Aussi, grâce au contrôle des barrières de potentiel exercé par les premières grilles, les deuxièmes grilles et les quatrièmes grilles, il est possible de réaliser un confinement électrostatique des particules chargées au-dessous des troisièmes grilles de la pluralité de troisièmes grilles pour former une boite quantique sous chaque troisième grille.

Par ailleurs, dans chaque boite quantique, le ou les particules chargées présentes sont associées à un potentiel chimique. Or, chaque troisième grille n'étant pas « écrantée » par une couche conductrice (autrement dit, il n'y a pas de couche conductrice entre l'oxyde des troisièmes grilles et la couche active), chaque troisième grille de la pluralité de troisièmes grilles permet, lorsqu'on lui applique un potentiel électrique, de modifier le potentiel chimique des particules chargées présentes dans boite quantique associé à la troisième grille considérée.

Outre les caractéristiques qui viennent d'être évoquées dans le paragraphe précédent, le dispositif selon le premier aspect de l'invention peut présenter une ou plusieurs caractéristiques complémentaires parmi les suivantes, considérées individuellement ou selon toutes les combinaisons techniquement possibles.

Dans un mode de réalisation, chaque quatrième grille est configurée pour former une barrière électrostatique entre deux troisièmes grilles situées de part et d'autre de ladite quatrième grille selon une diagonale ; et chaque troisième grille est configurée pour contrôler le potentiel chimique d'une portion de la couche active se trouvant à l'aplomb de ladite troisième grille.

Ladite barrière électrostatique est par exemple formée entre des portions de la couche active se trouvant à l'aplomb desdites deux troisièmes grilles.

Avantageusement, chaque première grille de la pluralité de premières grilles s'étend entièrement sur la couche active, chaque deuxième grille de la pluralité de deuxièmes grilles s'étend entièrement sur la couche active, chaque troisième grille de la pluralité de troisièmes grilles s'étend entièrement sur la couche active, chaque quatrième grille de la pluralité de quatrièmes grilles s'étend entièrement sur la couche active.

Dans un mode de réalisation, chaque grille des pluralités de premières, deuxièmes, troisièmes et quatrièmes grilles, s'étend sur une première dimension, dite première largeur, mesurée selon une ligne ou une colonne, la couche active présentant une deuxième dimension, dite deuxième largeur, mesurée selon ladite ligne ou ladite colonne, supérieure ou égale à la première largeur.

Dans un mode de réalisation, la couche active s'étend sous chaque première grille et au-delà de ladite première grille ; et la couche active s'étend sous chaque deuxième grille et au-delà de ladite deuxième grille ; et la couche active s'étend sous chaque troisième grille et au-delà de ladite troisième grille ; et la couche active s'étend sous chaque quatrième grille et au-delà de ladite quatrième grille.

Dans un mode de réalisation, chaque première grille présente une longueur et une largeur, inférieure ou égale à la longueur, chaque première grille étant disposée de sorte que sa longueur soit alignée avec une ligne de la pluralité de lignes ; et chaque deuxième grille présente une longueur et une largeur, inférieure ou égale à la longueur, chaque deuxième grille étant disposée de sorte que sa longueur soit alignée avec une colonne de la pluralité de colonne.

Dans un mode de réalisation, chaque première grille et chaque deuxième grille présente une longueur et une épaisseur strictement inférieure à la longueur. La longueur est préférentiellement mesurée parallèlement à la couche active et l'épaisseur est mesurée perpendiculairement à la couche active.

Dans un mode de réalisation, chaque troisième grille présente une forme d'étoile à quatre branches dont une première diagonale, passant par deux branches opposées, est parallèle à une ligne de la pluralité de lignes, et dont une deuxième diagonale, distincte de la première diagonale et passant par deux autres branches opposées, est parallèle à une colonne de la pluralité de colonne.

Dans un mode de réalisation, chaque première grille présente une forme rectangulaire dont une troisième diagonale, passant par deux sommets opposés, présente un angle avec une ligne de la pluralité de lignes, inférieur ou égal à 45° ; et chaque deuxième grille présente également une forme rectangulaire dont une quatrième diagonale, passant par deux sommets opposés, présente un angle avec une colonne de la pluralité de colonnes, inférieur ou égale à 45°.

Dans un mode de réalisation, les premières, deuxièmes, troisièmes et quatrièmes grilles sont disposées à une même distance de la couche active.

Dans un mode de réalisation, le dispositif comprend une première couche diélectrique s'étendant sur la couche active, chaque première grille, chaque deuxième grille, chaque troisième grille et chaque quatrième grille s'étendant sur la première couche diélectrique. La première couche diélectrique est préférentiellement commune à toutes les grilles.

Dans un mode de réalisation, la pluralité de premières grilles est polarisable indépendamment de la pluralité de troisièmes grilles et de la pluralité de quatrièmes grilles.

Dans un mode de réalisation, la pluralité de deuxièmes grilles est polarisable indépendamment de la pluralité de troisièmes grilles et de la pluralité de quatrièmes grilles.

Dans un mode de réalisation, la pluralité de troisièmes grilles est polarisable indépendamment de la pluralité de quatrièmes grilles.

Dans un mode de réalisation, chaque pluralité de grilles parmi les pluralités de premières, deuxièmes, troisièmes et quatrièmes grilles, est polarisable indépendamment des autres pluralités de grilles parmi les pluralités de premières, deuxièmes, troisièmes et quatrièmes grilles.

Dans un mode de réalisation, chaque grille parmi les premières, deuxièmes, troisièmes et quatrièmes grilles est polarisable indépendamment des autres grilles parmi les premières, deuxièmes, troisièmes et quatrièmes grilles.

Dans un mode de réalisation, chaque première grille est polarisable indépendamment des autres premières grilles et des deuxièmes, troisièmes et quatrièmes grilles ; et chaque deuxième grille est polarisable indépendamment des autres deuxièmes grilles et des premières, troisièmes et quatrièmes grilles ; et chaque troisième grille est polarisable indépendamment des autres troisièmes grilles et des premières, deuxième et quatrièmes grilles ; et chaque quatrième grille est polarisable indépendamment des autres quatrièmes grilles et des premières, deuxième et troisièmes grilles.

Par « grille polarisable indépendamment des autres grilles », on entend qu'il est possible est possible d'appliquer un potentiel électrique sur ladite grille sans appliquer ledit potentiel sur les autres grilles.

Par « pluralité de premières grilles polarisables indépendamment d'une autre pluralité de grilles », on entend qu'il est possible est possible d'appliquer un potentiel électrique sur chacune des premières grilles, sur un sous-ensemble de premières grilles, ou sur toutes les premières grilles, sans appliquer ledit potentiel sur aucune autre grille des autres pluralités de grilles.

Dans un mode de réalisation, deux quatrièmes grilles adjacentes, agencées parallèlement à une ligne, sont séparées par une deuxième grille ; et deux quatrièmes grilles adjacentes, agencées parallèlement à une colonne, sont séparées une première grille ; et deux quatrièmes grilles adjacentes, agencées selon une diagonale sont séparées par une troisième grille.

Une diagonale s'étend par exemple avec un angle de 45° par rapport à une ligne et par rapport à une colonne.

Dans un mode de réalisation, le dispositif est réalisé à partir d'un substrat de type « silicium sur isolant » (ou SOI pour Silicon On Insulator en anglais), la couche active étant réalisée dans la couche de silicium du substrat située au-dessus de l'oxyde.

Dans un mode de réalisation, le dispositif est réalisé à partir d'un substrat de silicium massif. Avantageusement, le substrat comprend une couche de silicium epitaxiée recouverte d'un oxyde thermique. Dans ce mode de réalisation, la couche active étant réalisée dans la couche de silicium, de préférence epitaxiée.

Dans un mode de réalisation, le dispositif est réalisé à partir d'une hétérostructure Si/SiGe, la couche active étant réalisée dans la couche Si.

Dans un mode de réalisation, le dispositif est réalisé à partir d'une hétérostructure Ge/SiGe, la couche active étant réalisée dans la couche Ge.

Dans un mode de réalisation, le dispositif comprend des espaceurs disposés de sorte à séparer chaque premières grilles, deuxièmes grilles, troisièmes grilles et quatrièmes grilles des premières grilles, deuxièmes grilles, troisièmes grilles et quatrièmes grilles adjacentes.

Dans un mode de réalisation, le dispositif comprend avantageusement des espaceurs disposés de sorte à :
- séparer chaque première grille des premières, deuxièmes, troisièmes et quatrième grilles adjacentes ;
- séparer chaque deuxième grille des premières, deuxièmes, troisièmes et quatrième grilles adjacentes ;
- séparer chaque troisième grille des premières, deuxièmes, troisièmes et quatrième grilles adjacentes ; et
- séparer chaque quatrième grille des premières, deuxièmes, troisièmes et quatrième grilles adjacentes.

Dans un mode de réalisation, chaque première grille, deuxième grille, troisième grille et quatrième grille comprend une électrode de grille et un oxyde de grille, et le matériau de l'électrode et de l'oxyde de grille des premières grilles, des deuxièmes grilles, des troisièmes grilles et des quatrièmes grilles sont identiques.

Dans un mode de réalisation, l'oxyde des premières, deuxièmes, troisièmes et/ou quatrièmes grilles est choisi parmi le SiO₂, le HfO₂ ou bien l'Al₂O₃.

Dans un mode de réalisation, l'épaisseur de l'oxyde des premières grilles, deuxièmes grilles troisièmes grilles et/ou quatrièmes grilles est comprise entre 5 nm et 10 nm.

Dans un mode de réalisation, les électrodes des premières grilles, deuxièmes grilles, troisièmes grilles et/ou quatrièmes grilles sont réalisées dans un matériau conducteur choisi parmi le Ti, le TiN, du poly-Si ou bien encore le W.

Un deuxième aspect de l'invention concerne un procédé de fabrication d'un dispositif semi-conducteur à partir d'un substrat comportant une couche semi-conductrice, dite couche active, au niveau d'une première surface dudit substrat (c'est-à-dire sur une première surface dudit substrat ou proche de la première surface dudit substrat), le procédé comprenant :
- Une étape de dépôt d'une première couche diélectrique sur la première surface ;
- Une étape de dépôt d'une couche support dans un matériau conducteur ou diélectrique sur la première couche diélectrique ;
- Une étape de gravure de la couche support de sorte à former une matrice de premiers piliers formant une pluralité de lignes et une pluralité de colonnes, les premiers piliers formant les quatrièmes grilles lorsque la couche support est dans un matériau conducteur ;
- Une étape de dépôt conforme d'une deuxième couche diélectrique sur la matrice de premiers piliers, l'épaisseur déposée étant choisie de sorte à combler l'espace entre chaque premier pilier et ses plus proches voisins ;
- Une étape de gravure de la deuxième couche diélectrique de sorte à exposer la première couche diélectrique entre chaque premier pilier de la matrice de premiers piliers selon les diagonales de ladite matrice de premiers piliers ;
- Une étape de dépôt d'une première couche conductrice de sorte à combler les ouvertures réalisées lors de l'étape de gravure de la deuxième couche diélectrique ;
- une étape de polissage mécano-chimique de la structure obtenue à l'issue de l'étape précédente de sorte à obtenir une matrice de deuxièmes piliers conducteurs au niveau des ouvertures réalisées lors de l'étape de gravure de la deuxième couche diélectrique, l'arrêt du polissage se faisant sur la couche support de sorte que les deuxièmes piliers conducteurs ne sont plus en contact entre eux à l'issue de cette étape et forment les troisièmes grilles ;
- Une étape de retrait sélectif de la deuxième couche diélectrique de sorte à ne conserver sur la première couche diélectrique que la matrice de premiers piliers et la matrice de deuxièmes piliers ;
- Une étape de dépôt conforme d'une troisième couche diélectrique sur la matrice de premiers piliers et la matrice de deuxièmes piliers, l'épaisseur déposée étant choisie de sorte à combler l'espace entre chaque premier pilier et les deuxièmes piliers conducteurs plus proches voisins dudit premier pilier ;

- Une étape de gravure de la troisième couche diélectrique de sorte à exposer la première couche diélectrique entre chaque premier pilier de la matrice de premiers piliers selon les lignes et les colonnes de ladite matrice de premiers piliers ;
- Une étape de dépôt d'une deuxième couche conductrice de sorte à combler les ouvertures réalisées lors de l'étape de gravure de la troisième couche diélectrique ;
- une étape de polissage mécano-chimique de la structure obtenue à l'issue de l'étape précédente, de sorte à obtenir une matrice de troisièmes piliers conducteur au niveau des ouvertures réalisées lors de l'étape de gravure de la troisième couche diélectrique, l'arrêt du polissage se faisant sur la couche support de sorte que les troisièmes piliers conducteurs ne sont en contact entre eux à l'issue de cette étape et forment les premières grilles et les deuxièmes grilles ;
- Lorsque le matériau de la couche support est un matériau diélectrique, une étape de retrait sélectif des premiers piliers de la pluralité de premiers piliers de sorte à exposer la première couche diélectrique au niveau de l'emplacement desdits premiers piliers ;
- Lorsque le matériau de la couche support est un matériau diélectrique, une étape de dépôt d'une troisième couche conductrice dans l'espace laissé par les premiers piliers lors de l'étape de retrait sélectif précédente ;
- Lorsque le matériau de la couche support est un matériau diélectrique, une étape de polissage mécano-chimique de la structure obtenue à l'issue de l'étape précédente, de sorte à obtenir une matrice de quatrièmes piliers conducteurs à l'emplacement des premiers piliers, l'arrêt du polissage se faisant de sorte que les quatrièmes piliers conducteurs ne sont plus en contact entre eux à l'issue de cette étape.

Grâce au procédé selon l'invention, il est possible d'obtenir un dispositif selon l'invention par auto-alignement en ayant recours qu'à un seul niveau de lithographie. Le procédé est ainsi grandement simplifié par rapport aux procédés de l'état de la technique dans lesquelles plusieurs niveaux de lithographie (et donc pour lesquels un alignement précis est nécessaires) et/ou un écrantage partiel des grilles entres elles) sont présents.

Outre les caractéristiques qui viennent d'être évoquées dans le paragraphe précédent, le procédé selon le deuxième aspect de l'invention peut présenter une ou plusieurs caractéristiques complémentaires parmi les suivantes, considérées individuellement ou selon toutes les combinaisons techniquement possibles.

Dans un mode de réalisation, le substrat est un substrat de type « silicium sur isolant » et la couche active est réalisé dans la couche de silicium du substrat située au-dessus de l'oxyde.

Dans un mode de réalisation, le matériau de la première couche diélectrique est choisi parmi le SiO2, le HfO2 ou bien encore l'Al2O3.

Dans un mode de réalisation, la distance d séparant deux premiers piliers voisins et la hauteur h des premiers piliers à l'issue de l'étape de gravure de la couche support de sorte à former une matrice de premiers piliers sont choisis de sorte que h> d/2.

Dans un mode de réalisation, le procédé comprend, à l'issue de l'étape de gravure de la deuxième couche diélectrique, une étape de polissage mécano-chimique de la structure obtenue à l'issue de l'étape précédente.

Dans un mode de réalisation, le procédé comprend, avant l'étape de gravure de la troisième couche diélectrique, une étape de polissage mécano-chimique de la structure obtenue à l'issue de l'étape précédente.

Dans un mode de réalisation, le procédé comprend, après l'étape de polissage mécano-chimique de la structure obtenue à l'issue de l'étape de dépôt d'une deuxième couche conductrice, une étape de sur polissage mécano-chimique de la structure obtenue à l'issue de l'étape de polissage mécano-chimique précédente.

L'invention et ses différentes applications seront mieux comprises à la lecture de la description qui suit et à l'examen des figures qui l'accompagnent.

### BRÈVE DESCRIPTION DES FIGURES

Les figures sont présentées à titre indicatif et nullement limitatif de l'invention.
La [Fig. 1] montre une représentation schématique d'un dispositif selon l'invention.
Les [Fig. 2A] à [Fig. 2C] montrent une représentation schématique de différents substrats susceptibles d'être utilisés dans un dispositif ou un procédé selon l'invention.
La [Fig. 3] montre une représentation schématique d'un substrat de type SOI utilisé dans un procédé selon l'invention et servant dans les illustrations des différentes étapes du procédé.
La [Fig. 4A] à la [Fig. 4J] montrent une représentation schématique des étapes du procédé selon l'invention (le ou les étapes associées à chaque figure figurant entre parenthèses).

### DESCRIPTION DÉTAILLÉE

Sauf précision contraire, un même élément apparaissant sur des figures différentes présente une référence unique.

### Dispositif quantique destiné à former une matrice de boites quantiques

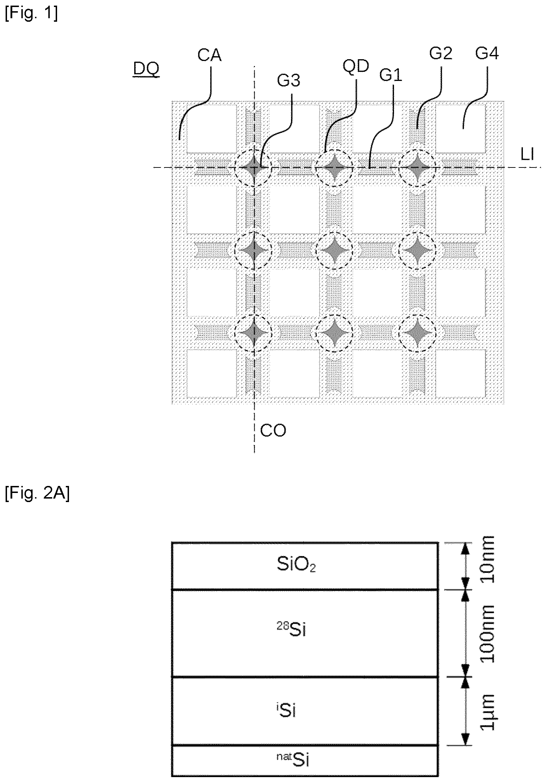

Un premier aspect de l'invention illustré à la [Fig. 1] concerne un dispositif quantique DQ configuré pour former une matrice de boites quantiques QD. Pour cela, le dispositif DQ comprend une couche active CA réalisée dans un matériau semi-conducteur. De préférence, cette couche CA est une couche de silicium (Si) ou de germanium (Ge), mais d'autres matériaux semi-conducteurs peuvent être envisagés. C'est dans cette couche active CA que seront formées les boites quantiques QD. Pour mémoire, une boite quantique QD est formée par un puits de potentiel électrostatique dans lequel il est possible de piéger une ou plusieurs particules chargées, par exemple un ou plusieurs trous ou un ou plusieurs électrons.

Le dispositif QD selon l'invention comprend également une pluralité de premières grilles G1 disposées selon une pluralité de lignes LI, au-dessus de la couche active CA. Le dispositif selon l'invention comprend également une pluralité de deuxièmes grilles G2 disposées selon une pluralité de colonnes CO perpendiculaires aux lignes LI de la pluralité de lignes LI, au-dessus de la couche active CA. Le dispositif DQ selon l'invention comprend en outre une pluralité de troisièmes grilles G3, chaque troisième grille G3 de la pluralité de troisièmes grilles G3 étant disposée à l'intersection d'une ligne LI de la pluralité de lignes LI et d'une colonne CO de la pluralité de colonnes CO, au-dessus de la couche active CA, chaque troisième grille G3 étant séparée des troisièmes grilles G3 les plus proches, sur une ligne LI par une première grille G1 et sur une colonne CO par une deuxième grille G2. Enfin, le dispositif DQ selon l'invention comprend une pluralité de quatrièmes grilles G4, chaque quatrième grille G4 étant disposée entre deux deuxièmes grilles G2 selon les lignes LI et entre deux première grille G1 selon les colonnes CO, au-dessus de la couche active CA.

Les premières grilles G1 sont séparées les unes des autres. Elles sont également séparées des deuxièmes, troisièmes et quatrièmes grilles. Ainsi, chaque première grille G1 est polarisable indépendamment des autres grilles. Ceci permet d'appliquer un potentiel électrique sur chaque grille sans polariser dans le même temps les grilles adjacentes. De la même manière les deuxièmes, troisièmes et quatrième grilles sont séparées les unes des autres de manière à être polarisables indépendamment des autres grilles.

Ainsi, dans le dispositif DQ selon l'invention, une boite quantique QD pourra être formée au-dessous de chaque troisième grille G3 de sorte à former une matrice de boites quantiques QD. En effet, chaque première grille G1 de la pluralité de premières grilles G1 permet, lorsqu'on lui applique un potentiel électrique, de modifier la barrière de potentiel séparant deux parties de la couche active CA situées sous deux troisièmes grilles G3 adjacentes selon les lignes. De même, chaque deuxième grille G2 de la pluralité de deuxièmes grilles G2 permet, lorsqu'on lui applique un potentiel électrique, de modifier la barrière de potentiel séparant deux parties de la couche active CA situées sous deux troisièmes grilles G3 adjacentes selon les colonnes CO. De plus, chaque quatrième grille G4 de la pluralité de quatrièmes grilles G4 permet, lorsqu'on lui applique un potentiel électrique, de former une barrière de potentiel garantissant l'absence de particule chargé au-dessous de ladite grilles G4, c'est-à-dire en dire entre les lignes et les colonnes de la matrice. En outre, les première grilles G1, deuxièmes grilles G2 et les quatrièmes grilles G4 permettent d'effectuer cette modification de manière locale, ces dernières G1, G2, G4 étant en au-dessus de la couche active CA (autrement dit, il n'y a pas de couche conductrice entre l'oxyde des première grilles G1, des deuxièmes grilles G3 et des quatrièmes grilles G4 et la couche active CA). Aussi, grâce au contrôle des barrières de potentiel exercé par les première grilles G1, les deuxièmes grilles G2 et les quatrièmes grilles G4, il est possible de réaliser un confinement électrostatique des particules chargées au-dessous des troisièmes grilles G3 de la pluralité de troisièmes grilles G3 pour former une boite quantique QD sous chaque troisième grille G3.

Par ailleurs, dans chaque boite quantique QD, le ou les particules chargées présentes sont associées à un potentiel chimique. Or, chaque troisième grille G3 étant au-dessus de la partie de la couche active CA dans laquelle est formée une boite quantique (autrement dit, il n'y a pas de couche conductrice entre l'oxyde des troisièmes grilles G3 et la couche active CA), chaque troisième grille G3 de la pluralité de troisièmes grilles G3 permet, lorsqu'on lui applique un potentiel électrique, de modifier le potentiel chimique des particules chargées présentes dans boite quantique QD associé à la troisième grille G3 considérée.

Dans le mode de réalisation de la [Fig. 1], le dispositif comprend une unique couche active CA. L'intégralité des premières, deuxièmes, troisièmes grilles G1, G2, G3, G4 s'étendent entièrement au-dessus de la couche active CA. Aucune grille ne s'étend qu'en partie au-dessus de la couche active CA. En d'autres termes, la couche active CA s'étend sous chaque première, deuxième, troisième et quatrième grilles G1, G2, G3, G4 et même au-delà de chaque grille précitée.

Dans le mode de réalisation de la [Fig. 1], chaque première grille G1 et chaque deuxième grille G2 présente une forme rectangulaire. Chaque grille présente ainsi une longueur et une largeur, mesurées dans le plan (c'est-à-dire parallèlement à la couche active CA), la longueur étant supérieure ou égale à la largeur. Chaque première grille G1 est disposée de sorte que sa longueur soit alignée parallèlement aux lignes LI. Chaque deuxième grille G2 est disposée de sorte que sa longueur soit alignée parallèlement aux colonne CO. Cet alignement particulier peut être le résultat du procédé de fabrication selon l'invention, détaillé ci-après.

Les premières et deuxièmes grilles G1, G2 peuvent également présenter une épaisseur, mesurée perpendiculairement au plan. Pour chaque grille G1, G2, son épaisseur est avantageusement inférieure à sa longueur.

Dans la [Fig. 1], chaque troisième grille G3 présente une forme d'étoile à quatre branches. Chacune des branches est alignée selon une ligne LI ou une colonne CO. Autrement dit, chaque troisième grille G3 présente une première diagonale, passant par deux des branches opposées, parallèle à la ligne LI sur laquelle se trouve ladite grille G3. Chaque troisième grille G3 présente également une deuxième diagonale distincte de la première diagonale, passant par deux autres des branches opposées, parallèle à la colonne CO sur laquelle se trouve ladite grille G3. La forme et l'orientation de cette forme pour les troisièmes grilles G3 peut être le résultat sur procédé de fabrication mis en oeuvre.

Ainsi, chaque première ou deuxième grille G1, G2, adjacente d'une troisième grille G3, a sa longueur qui est alignée selon l'une des branches de ladite troisième grille G3.

De manière plus précise, les premières et deuxièmes grilles G1, G2 peuvent présenter des pointes, du fait de leur forme rectangulaire. Chacune des premières et deuxièmes grilles G1, G2 peut présenter une troisième diagonale, passant par deux des sommets opposés de ladite grille. Cette troisième diagonale présente avantageusement un angle avec l'une ligne LI qui est inférieur ou égal à 45°. Autrement dit, la troisième diagonale d'une première ou deuxième grille G1, G2, présente un angle avec l'une des deux diagonales d'une troisième grille adjacente G3, qui est inférieur ou égal à 45°.

Les quatrièmes grilles G4 peuvent présenter une forme rectangulaire ou une forme carrée.

Les quatrièmes grilles G4 peuvent être agencées sur une matrice de lignes et de colonnes selon la même période de répartition que les troisièmes grilles G3. Elles sont toutefois décalées pour venir s'insérer dans la matrice de lignes LI et de colonnes CO formées par les premières, deuxièmes et troisièmes grilles G1, G2, G3. Les quatrièmes grilles sont par exemple agencées de sorte que :
- deux quatrièmes grilles G4 adjacentes, agencées parallèlement à une ligne LI, soient séparées par une deuxième grille G2 et de préférence une seule deuxième grilles G2 ; et
- deux quatrièmes grilles G4 adjacentes, agencées parallèlement à une colonne CO, soient séparées une première grille G1 et de préférence une seule première grille G1 ; et
- deux quatrièmes grilles G4 adjacentes, agencées parallèlement à une diagonale aux lignes LI et aux colonnes CO (c'est-à-dire s'étendant selon une direction de 45° par rapport aux lignes LI et aux colonnes CO) soient séparées par une troisième grille G3 et de préférence une seule troisième grilles G3.

Cet agencement de quatrièmes grilles G4 par rapport aux troisièmes grilles G3 permet de former une barrière de potentiel entre deux boîtes quantiques se trouvant sous deux troisièmes grilles G3 adjacentes selon une diagonale.

Les troisièmes grilles G3 peuvent ainsi librement contrôler le potentiel chimique des boîtes quantiques situées à leur aplomb, sans risquer de moduler le potentiel chimique des boîtes quantiques voisines.

Les premières, deuxièmes, troisièmes et quatrièmes grilles G1, G2, G3, G4 présentent avantageusement une même distance, à 10 % près, avec la couche active CA. Ceci permet d'obtenir un couplage grille/couche active sensiblement identique. Les premières, deuxièmes, troisièmes et quatrièmes grilles G1, G2, G3, G4 sont par exemple séparées de la couche active CA par une couche diélectrique.

Dans un mode de réalisation, l'oxyde des premières G1, deuxièmes G2, troisièmes G3 et/ou quatrièmes grilles G4 est choisi parmi le SiO₂, le HfO₂ ou bien l'Al₂O₃. Dans un mode de réalisation, l'épaisseur de l'oxyde des premières grilles G1, deuxièmes grilles G2, troisièmes grilles G3 et/ou troisièmes grilles G4 est comprise entre 5 nm et 10 nm. Dans un mode de réalisation, les électrodes des premières grilles G1, deuxièmes grilles G2, troisièmes grilles G3 et/ou quatrièmes grilles G3 sont réalisées dans un matériau conducteur choisi parmi le Ti, le TiN ou bien encore le W. Dans un mode de réalisation, le dispositif selon l'invention est réalisé dans un substrat de type SOI et la couche active est une couche de silicium. Dans ce mode de réalisation, les premières, deuxièmes, troisièmes et quatrièmes grilles G1, G2, G3, G4 sont au contact direct de la couche active CA.

Dans un mode de réalisation alternatif, le dispositif est réalisé à partir d'un substrat de silicium massif. Avantageusement, le substrat comprend une couche de silicium épitaxiée (notée ²⁸Si sur la figure) recouverte d'un oxyde thermique (noté SiO₂ sur la figure), cette couche de silicium épitaxiée étant déposée sur la couche de silicium intrinsèque (noté ⁱSi sur la figure) du substrat de silicium massif. Un tel substrat est illustré à la [Fig. 2A]. Dans ce mode de réalisation, la couche active CA est réalisée dans la couche de silicium, avantageusement la couche de silicium epitaxiée. Les dimensions indiquées sur la figure sont bien entendu données à titre purement illustratif.

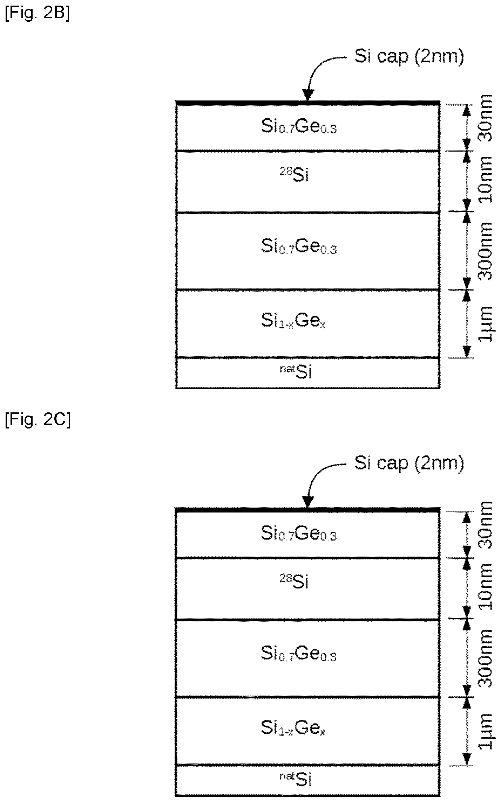

Dans un mode de réalisation alternatif, le dispositif est réalisé à partir d'une hétérostructure Si/SiGe. Un substrat comprenant une telle hétérostructure est illustré à la [Fig. 2B]. Cette dernière comprend une couche dont la concentration en Ge évolue de manière linéaire (notée Si₁₋ₓGeₓ sur la figure) sur laquelle repose une couche de SiGe (notée Si_{0.7}Ge_{0.3}), un puit quantique destiné aux électrons formé dans une couche de Si (notée ²⁸Si sur la figure), un espaceur en SiGe (noté Si_{0.7}Ge_{0.3} sur la figure) situé sur la couche de Si et une couche de silicium (notée Si Cap sur la figure). Dans ce mode de réalisation, la couche active est réalisée dans la couche Si. Les dimensions indiquées sur la figure sont bien entendu données à titre purement illustratif.

Dans un mode de réalisation alternatif, le dispositif est réalisé à partir d'une hétérostructure Ge/SiGe. Un substrat comprenant une telle hétérostructure est illustré à la [Fig. 2C]. Cette dernière comprend une couche dont la concentration en Si évolue de manière linéaire (notée Si₁₋ₓGeₓ sur la figure) sur laquelle repose une couche de SiGe (notée Si_{0.2}Ge_{0.8}), un puit quantique destiné aux trous formé dans une couche de Ge (notée Ge sur la figure), un espaceur en SiGe (noté Si_{0.2}Ge_{0.8} sur la figure) situé sur la couche de Ge et une couche de silicium (noté Si Cap sur la figure). Dans ce mode de réalisation, la couche active est réalisée dans la couche Ge. Les dimensions indiquées sur la figure sont bien entendu données à titre purement illustratif.

### Procédé de fabrication d'un dispositif quantique comportant une matrice d'îlots

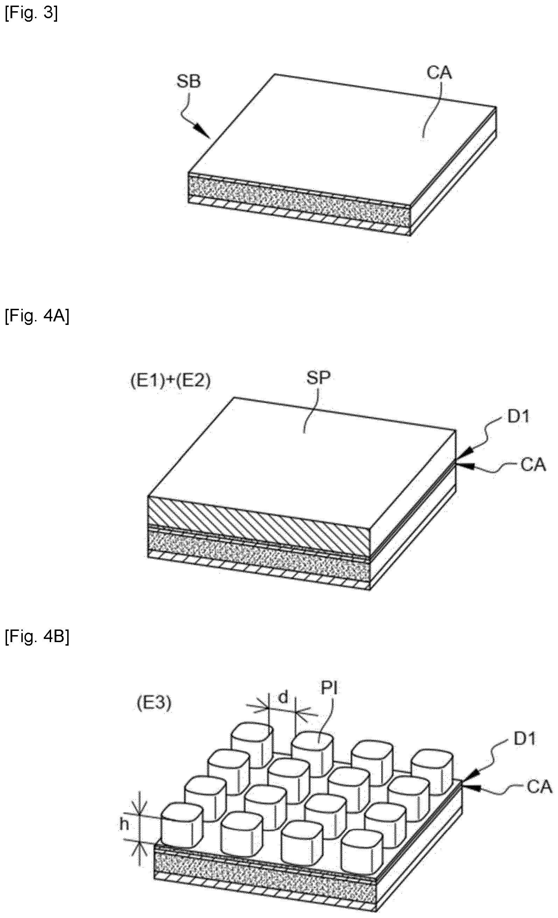

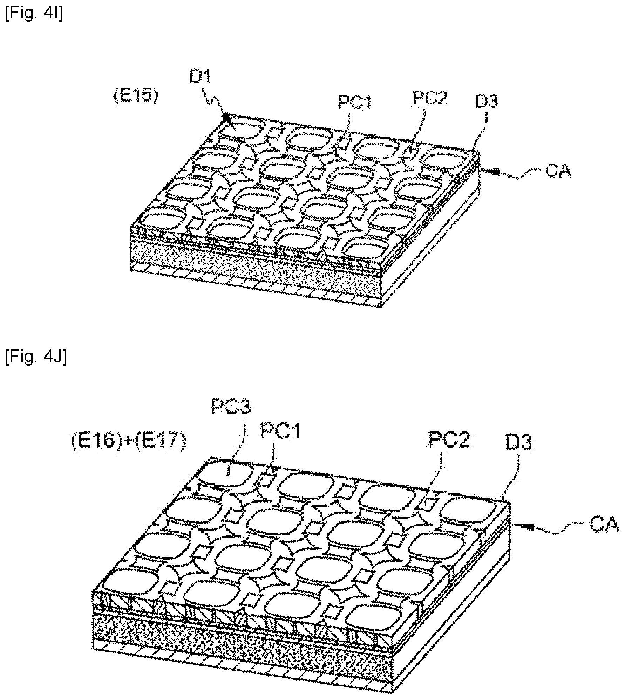

Un deuxième aspect de l'invention illustré au [Fig. 3] à [Fig. 4J] concerne un procédé de fabrication d'un dispositif semi-conducteur selon l'invention à partir d'un substrat SB comportant une couche semi-conductrice, dite couche active CA, sur une première surface dudit substrat SB ou proche de la première surface. On entend par proche de la première surface que la distance séparant la couche active de la première surface est inférieure à la distance séparant la couche active de la deuxième surface du substrat opposée à la première surface. De préférence la distance séparant la couche active CA de la première surface du substrat SB est inférieure à 500 nm, de préférence inférieure à 200 nm, voire inférieure à 100 nm. Dans un mode de réalisation, l'épaisseur de la couche active CA est comprise entre 5 et 20 nm, par exemple égale à 10 nm.

Dans un mode de réalisation, la couche active CA est en silicium, le substrat étant de préférence un substrat de type SOI (pour Silicon-On-Insulator en anglais). Dans un mode de réalisation alternatif, le substrat est un substrat de type SiMOS tel que décrit précédemment. Dans un mode de réalisation alternatif, le substrat comprend une hétérostructure Si/SiGe tel que décrite précédemment au niveau de sa première surface. Dans un mode de réalisation alternatif, le substrat comprend une hétérostructure Ge/SiGe tel que décrite précédemment au niveau de sa première surface.

Le procédé selon l'invention comprend une étape E1 de dépôt d'une première couche diélectrique D1 sur la première surface. Lorsque la couche active CA est au niveau de cette première surface (comme illustré aux [Fig.3] à [Fig. 4J], alors ce dépôt est effectué sur la couche active CA. Dans un mode de réalisation, le matériau de la première couche diélectrique D1 est choisi parmi le SiO₂, le HfO₂ ou bien encore l'Al₂O₃. Dans un mode de réalisation, la première couche diélectrique D1 est réalisée dans un matériau diélectrique à haute permittivité. Dans un mode de réalisation, le première couche diélectrique D1 comporte plusieurs sous-couches diélectriques. Par exemple, elle comporte une première sous-couche de SiO₂ assurant une bonne qualité d'interface avec la couche sur laquelle elle est déposée (par exemple la couche active de Si), puis une deuxième sous-couche de HfO₂ ou d'Al₂O₃. Il ne s'agit bien entendu que d'un exemple et d'autres combinaisons peuvent être envisagées.

Le procédé comprend ensuite une étape E2 de dépôt d'une couche support SP sur la première couche diélectrique D1. Dans un mode de réalisation, le matériau de la couche support SP est un matériau diélectrique, par exemple du nitrure de silicium. Dans un mode de réalisation alternatif, le matériau de la couche support SP est un matériau conducteur, par exemple un métal. La structure obtenue à l'issue de ces deux étapes est illustrée à la [Fig. 4A].

Comme illustré à la [Fig. 4B], le procédé comprend ensuite une étape E3 de gravure de la couche support de sorte à former une matrice de premiers piliers PI formant une pluralité de lignes et une pluralité de colonnes. De préférence, la distance d séparant deux premiers piliers PI voisins et la hauteur h des premiers piliers PI sont choisis de sorte que h > d/2. De préférence, la hauteur h des premiers piliers est comprise entre 50 nm et 500 nm, par exemple égale à 200 nm.

Le procédé comprend également une étape E4 de dépôt conforme d'une deuxième couche diélectrique D2 sur la matrice de premiers piliers PI, l'épaisseur déposée étant choisie de sorte à combler l'espace entre chaque premier pilier PI et ses plus proches voisins. Dans un mode de réalisation, la couche diélectrique D2 est en SiO₂. Dans un mode de réalisation, le deuxième couche diélectrique D2 comporte plusieurs sous-couches diélectriques.

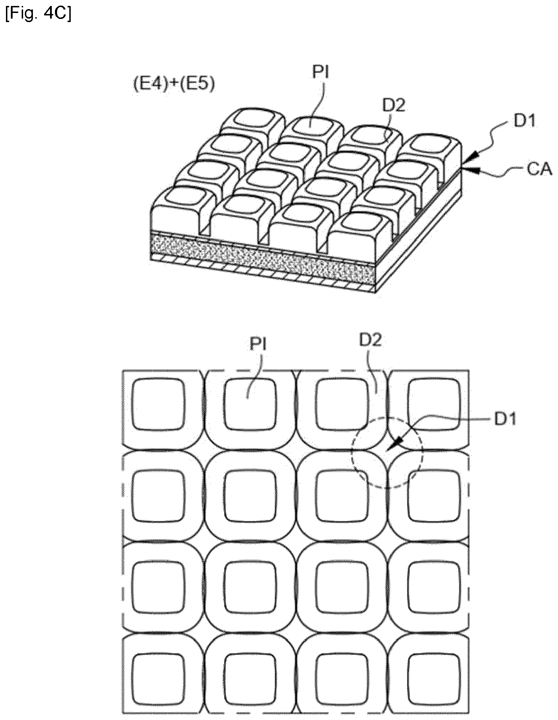

Le procédé comprend ensuite une étape E5 de gravure de la deuxième couche diélectrique D2 de sorte à exposer la première couche diélectrique D1 entre chaque premier pilier PI de la matrice de premiers piliers PI selon les diagonales de ladite matrice de premier piliers PI, la première couche diélectrique D1 servant de couche d'arrêt à la gravure. Dans un exemple de réalisation, la deuxième couche diélectrique D2 est une couche de SiO₂ et la première couche diélectrique D1 (servant de couche d'arrêt) est une couche de HfO₂ ou d'Al₂O₃. La structure obtenue à l'issue de ces deux étapes E4, E5 est illustrée à la [Fig. 4C], les zones exposées de la première couche diélectrique D1 étant marquées par un cercle en pointillé dans la représentation de dessus en bas de la figure.

Dans un mode de réalisation, le procédé comprend également une étape E6 de polissage mécano-chimique de la structure obtenue à l'issue de l'étape E5 précédente. Bien que facultative, cette étape E6 permet d'aplanir la surface de la structure et ainsi d'améliorer la qualité du dépôt de la première couche conductrice décrit dans la suite. En outre, réaliser le polissage mécano-chimique en deux temps permet d'éviter tout problème de sélectivité avec le polissage mécano-chimique effectué à l'issue du dépôt de la première couche conductrice décrit dans la suite.

Le procédé selon l'invention comprend ensuite une étape E7 de dépôt d'une première couche conductrice de sorte à combler les ouvertures réalisées lors de l'étape E5 de gravure de la deuxième couche diélectrique D2. Ainsi, au niveau de ces ouvertures, la couche conductrice est en contact direct avec la première couche diélectrique D1. Dans un mode de réalisation, le matériau de la couche conductrice est choisi parmi le Ti, TiN ou bien encore W.

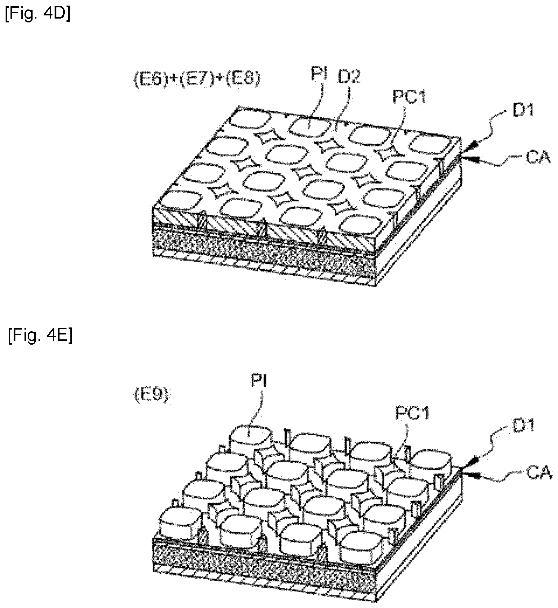

Le procédé selon l'invention comprend en outre une étape E8 de polissage mécano-chimique de la structure obtenue à l'issue de l'étape précédente de sorte à obtenir une matrice de deuxièmes piliers PC1 conducteurs au niveau des ouvertures réalisées lors de l'étape E5 de gravure de la deuxième couche diélectrique D2. Lors de cette étape E8, l'arrêt du polissage se fait sur la couche support SP de sorte que les deuxième piliers PC1 ne sont plus en contact entre eux à l'issue de cette étape E8. La structure obtenue à l'issue de ces deux étapes ou trois étapes (lorsque l'étape E6 facultative de polissage mécano-chimique est mise en oeuvre) est illustrée à la [Fig. 4D]. Dans la structure finale obtenue à l'issue du procédé selon l'invention, les deuxièmes piliers PC1 conducteurs viendront former les troisième grille G3 de la [Fig. 1] permettant de contrôler le potentiel chimique des particules chargées au niveau des boites quantiques QD.

Comme illustré à la [Fig. 4E], le procédé comprend ensuite une étape E9 de retrait sélectif de la deuxième couche diélectrique D2 de sorte à ne conserver sur la première couche diélectrique D1 que la matrice de premiers piliers PI et la matrice de deuxième piliers PC1. Lors de cette étape de retrait, la première couche diélectrique D1 est préservée et sert de couche d'arrêt.

Le procédé comprend ensuite une étape E10 de dépôt conforme d'une troisième couche diélectrique D3 sur la matrice de premiers piliers PI et sur la matrice de deuxièmes piliers PC1, l'épaisseur déposée étant choisie de sorte à combler l'espace entre chaque premier pilier PI et les deuxièmes piliers PC2 plus proches voisins dudit premier pilier PI.

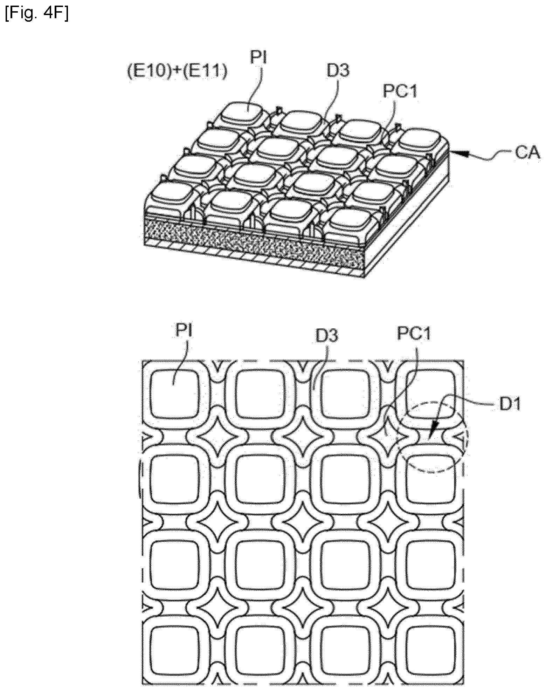

Le procédé comprend également une étape E11 de gravure de la troisième couche diélectrique D3 de sorte à exposer la première couche diélectrique D1 entre chaque premier pilier PI de la matrice de premiers piliers PI selon les lignes et les colonnes de ladite matrice de premiers piliers PI. La structure obtenue à l'issue de ces deux étapes est illustrée à la [Fig. 4F], les zones exposées de la première couche diélectrique D1 étant marquées par un cercle en pointillé.

Dans un mode de réalisation, le procédé comprend une étape de polissage mécano-chimique de la structure obtenue à l'issue de l'étape E11 précédente (non représentée sur les figures). Bien que facultative, cette étape permet d'aplanir la surface de la structure et ainsi d'améliorer la qualité du dépôt de la deuxième couche conductrice C2 décrit dans la suite. En outre, réaliser le polissage mécano-chimique en deux temps permet d'éviter tout problème de sélectivité avec le polissage mécano-chimique effectué à l'issue du dépôt de la deuxième couche conductrice C2 décrit dans la suite.

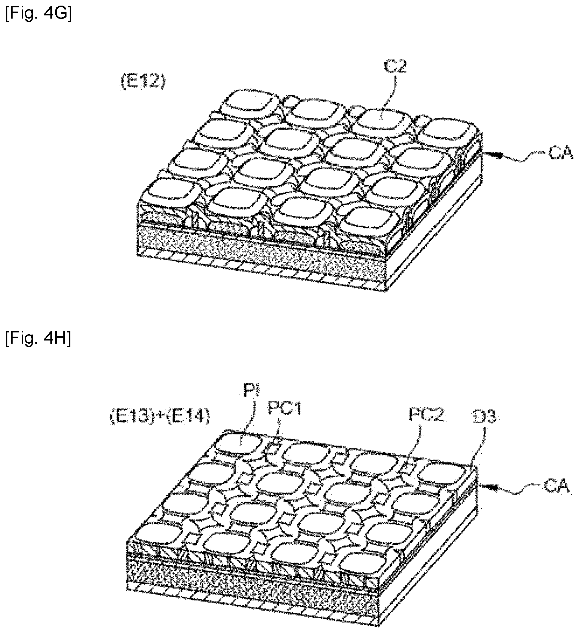

Comme illustré à la [Fig. 4G], le procédé comprend ensuite une étape E12 de dépôt d'une deuxième couche conductrice C2 de sorte à combler les ouvertures réalisées lors de l'étape E11 de gravure de la troisième couche diélectrique D3. Ainsi, au niveau de ces ouvertures, la deuxième couche conductrice C2 est en contact direct avec la première couche diélectrique D1. Dans un mode de réalisation, le matériau de la deuxième couche conductrice C2 est choisi parmi le Ti, TiN ou bien encore W.

Le procédé comprend ensuite une étape E13 de polissage mécano-chimique de la structure obtenue à l'issue de l'étape précédente, de sorte à obtenir une matrice de troisièmes piliers PC2 conducteurs, lesdits troisièmes piliers PC2 conducteurs étant en contact direct avec la première couche diélectrique D1 au niveau des ouvertures réalisées lors de l'étape E11 de gravure de la troisième couche diélectrique D3. Lors de cette étape E13, l'arrêt du polissage se fait sur la couche support SP de sorte que les troisième piliers PC2 ne sont plus connectés entre eux à l'issue de cette étape E13. Dans un mode de réalisation, afin de s'assurer de la bonne déconnexion des troisièmes piliers entre eux, une étape E14 de sur polissage mécano-chimique de la structure obtenue à l'issue de l'étape E13 précédente est mise en oeuvre. On entend par « sur polissage » le fait de continuer le polissage alors que la couche d'arrêt a été atteinte. En effet, la détection de l'atteinte des couches d'arrêt par le polissage se fait de façon automatique par détection physique d'un signal de polissage de la couche d'arrêt. Or, s'il existe des non-uniformités d'épaisseur à l'échelle de la plaque, il se peut que le signal soit détecté alors que la couche d'arrêt n'a pas été atteinte sur l'ensemble de la plaque, mais seulement sur une partie. Le « sur polissage » permet donc de poursuivre le polissage suffisamment longtemps après que le signal a été détecté de sorte que toutes les zones de la plaque soient polies suffisamment. La structure obtenue à l'issue de cette étape E13 ou de ces deux étapes (lorsque l'étape E14 facultative de sur polissage est mise en oeuvre) est illustrée à la [Fig. 4H]. Dans la structure finale, les troisième piliers PC2 conducteurs viendront former les premières grilles G1 et les deuxièmes grilles G2 de la [Fig. 1] permettant de contrôler la barrière de potentiel entre deux boites quantiques QD adjacentes.

Dans la structure finale, lorsque le matériau support est un matériau conducteur alors, la première pluralité de piliers PI viendra former la pluralité de quatrièmes grilles G4 de la [Fig. 1] permettant de contrôler l'absence de charge entre les lignes LI et les colonnes CO. Lorsqu'on revanche, le matériau support est un matériau diélectrique, il est nécessaire de retirer la première pluralité de piliers PI existant pour les substituer par des piliers conducteurs.

Pour cela, comme illustré à la [Fig. 4I], le procédé comprend, lorsque le matériau de la couche support SP est un matériau diélectrique une étape E15 de retrait sélectif des premiers piliers PI de la pluralité de premiers pilier PI de sorte à exposer la première couche diélectrique D1 au niveau de l'emplacement desdits premiers piliers PI. Cette étape de retrait peut être mise en oeuvre par un procédé de gravure humide sélective, par exemple à base de H₃PO₄.

Le procédé comprend ensuite, lorsque le matériau de la couche support SP est un matériau diélectrique, une étape E16 de dépôt d'une troisième couche conductrice dans l'espace laissé par les premiers piliers PI lors de l'étape E15 de retrait sélectif précédente.

Le procédé comprend enfin, lorsque le matériau de la couche support SP est un matériau diélectrique, une étape E17 de polissage mécano-chimique de la structure obtenue à l'issue de l'étape précédente, de sorte à obtenir une matrice de quatrièmes piliers PC3 conducteurs à l'emplacement des premiers piliers PI, l'arrêt du polissage se faisant de sorte que les quatrièmes piliers conducteurs ne sont plus connectés entre eux à l'issue de cette étape. La structure obtenue à l'issue de cette étape est illustrée à la [Fig. 4J]. Dans cette structure finale, la matrice de quatrièmes piliers PC3 viendra former la pluralité de quatrièmes grilles G4 de la [Fig. 1] permettant de contrôler l'absence de charge entres les lignes LI et les colonnes CO.

Comme le montrent la [Fig. 1] et la [Fig. 4J], dans le dispositif ainsi obtenu, les troisièmes grilles G3 présentent de préférence une symétrie centrale et la répartition des premières grilles G1 et deuxièmes grilles G2 adjacentes à chaque troisième grille G3 se fait selon cette symétrie. De même, le premières, deuxièmes et troisièmes grilles G1,G2,G3 sont préférentiellement réparties de manière symétrique par rapport à l'axe associé à chaque ligne LI et l'axe associé à chaque colonne CO.

## Revendications

1. Dispositif quantique (DQ) configuré pour former une matrice de boites quantiques (QD), le dispositif (DQ) comprenant :
- Une couche active (CA) réalisée dans un matériau semi-conducteur ;
- Une pluralité de premières grilles (G1) disposées selon une pluralité de lignes (LI) ;
- Une pluralité de deuxièmes grilles (G2) disposées selon une pluralité de colonnes (CO) perpendiculaires aux lignes (LI) de la pluralité de lignes (LI) ;
- Une pluralité de troisièmes grilles (G3), chaque troisième grille (G3) de la pluralité de troisièmes grilles (G3) étant disposée à l'intersection d'une ligne de la pluralité de lignes (LI) et d'une colonne de la pluralité de colonnes (CO), chaque troisième grille (G3) étant séparée des troisièmes grilles (G3) les plus proches, sur une ligne (LI) par une première grille (G1) et sur une colonne (CO) par une deuxième grille (G2) ;
- Une pluralité de quatrièmes grilles (G4), chaque quatrième grille (G4) étant disposée entre deux deuxièmes grilles (G2) selon deux lignes (LI) adjacentes et entre deux premières grilles (G1) selon deux colonnes (CO) adjacentes.

2. Dispositif (DQ) selon la revendication précédente **caractérisé en ce que** chaque quatrième grille (G4) est configurée pour former une barrière électrostatique entre deux troisièmes grilles (G3) situées de part et d'autre de ladite quatrième grille (G4) selon une diagonale ; et **en ce que** chaque troisième grille (G3) est configurée pour contrôler le potentiel chimique d'une portion de la couche active (CA) se trouvant à l'aplomb de ladite troisième grille.

3. Dispositif (DQ) selon l'une des revendications précédentes **caractérisé en ce que** chaque première grille de la pluralité de premières grilles s'étend entièrement sur la couche active (CA) ; et **en ce que** chaque deuxième grille de la pluralité de deuxièmes grilles s'étend entièrement sur la couche active (CA) ; et **en ce que** chaque troisième grille de la pluralité de troisièmes grilles s'étend entièrement sur la couche active (CA) ; et **en ce que** chaque quatrième grille de la pluralité de quatrièmes grilles s'étend entièrement sur la couche active (CA).

4. Dispositif (DQ) selon l'une des revendications précédentes caractérisé en ce chaque grille des pluralités de premières, deuxièmes, troisièmes et quatrièmes grilles (G1, G2, G3, G4), s'étend sur une première dimension, dite première largeur, mesurée selon une ligne ou une colonne, la couche active (CA) présentant une deuxième dimension, dite deuxième largeur, mesurée selon ladite ligne ou ladite colonne, supérieure ou égale à la première largeur.

5. Dispositif (DQ) selon l'une des revendications précédentes **caractérisé en ce que** chaque première grille présente une longueur et une largeur, inférieure ou égale à la longueur, chaque première grille étant disposée de sorte que sa longueur soit alignée avec une ligne de la pluralité de lignes ; et **en ce que** chaque deuxième grille présente une longueur et une largeur, inférieure ou égale à la longueur, chaque deuxième grille étant disposée de sorte que sa longueur soit alignée avec une colonne de la pluralité de colonne.

6. Dispositif (DQ) selon l'une des revendications précédentes **caractérisé en ce que** chaque troisième grille (G3) présente une forme d'étoile à quatre branches dont une première diagonale, passant par deux branches opposées, est parallèle à une ligne (LI) de la pluralité de lignes (LI), et dont une deuxième diagonale, distincte de la première diagonale et passant par deux autres branches opposées, est parallèle à une colonne (CO) de la pluralité de colonne (CO).

7. Dispositif (DQ) selon l'une des revendications précédentes **caractérisé en ce que** les premières, deuxièmes, troisièmes et quatrièmes grilles (G1, G2, G3, G4) sont disposées à une même distance de la couche active (CA).

8. Dispositif (DQ) selon l'une des revendications précédentes **caractérisé en ce qu'**il comprend une première couche diélectrique (D1) s'étendant sur la couche active (CA), chaque première grille (G1), chaque deuxième grille (G2), chaque troisième grille (G3) et chaque quatrième grille (G4) s'étendant sur la première couche diélectrique, la première couche diélectrique étant commune à toutes les grilles.

9. Dispositif (DQ) selon l'une des revendications précédentes **caractérisé en ce que** la pluralité de troisièmes grilles (G3) est polarisable indépendamment de la pluralité de quatrièmes grilles (G4).

10. Dispositif (DQ) selon l'une des revendications précédentes **caractérisé en ce que** chaque grille parmi les premières, deuxièmes, troisièmes et quatrièmes grilles (G1, G2, G3, G4) est polarisable indépendamment des autres grilles parmi les premières, deuxièmes, troisièmes et quatrièmes grilles (G1, G2, G3, G4).

11. Dispositif (DQ) selon l'une des revendications précédentes **caractérisé en ce que** deux quatrièmes grilles (G4) adjacentes, agencées parallèlement à une ligne (LI), sont séparées par une deuxième grille (G2) ; et **en ce que** deux quatrièmes grilles (G4) adjacentes, agencées parallèlement à une colonne (CO), sont séparées par une première grille (G1) ; et **en ce que** deux quatrièmes grilles (G4) adjacentes, agencées selon une diagonale sont séparées par une troisième grille (G3).

12. Dispositif selon l'une des revendications précédentes comprenant des espaceurs disposés de sorte à :
- séparer chaque première grille (G1) des premières, deuxièmes, troisièmes et quatrièmes grilles (G1, G2, G3, G4) adjacentes ;
- séparer chaque deuxième grille (G2) des premières, deuxièmes, troisièmes et quatrièmes grilles (G1, G2, G3, G4) adjacentes ;
- séparer chaque troisième grille (G3) des premières, deuxièmes, troisièmes et quatrièmes grilles (G1, G2, G3, G4) adjacentes ; et
- séparer chaque quatrième grille (G4) des premières, deuxièmes, troisièmes et quatrièmes grilles (G1, G2, G3, G4) adjacentes.

13. Procédé de fabrication d'un dispositif quantique (DQ) selon l'une des revendications précédentes à partir d'un substrat (SB) comportant une couche semi-conductrice, dite couche active (CA), au niveau d'une première surface dudit substrat (SB), le procédé comprenant :
- Une étape (E1) de dépôt d'une première couche diélectrique (D1) sur la première surface ;
- Une étape (E2) de dépôt d'une couche support (SP) dans un matériau conducteur ou diélectrique sur la première couche diélectrique (D1) ;
- Une étape (E3) de gravure de la couche support (SP) de sorte à former une matrice de premiers piliers (PI) formant une pluralité de lignes et une pluralité de colonnes, les premiers piliers formant les quatrièmes grilles (G4) lorsque la couche support (SP) est dans un matériau conducteur ;
- Une étape (E4) de dépôt conforme d'une deuxième couche diélectrique (D2) sur la matrice de premiers piliers (PI), l'épaisseur déposée étant choisie de sorte à combler l'espace entre chaque premier pilier (PI) et ses plus proches voisins ;
- Une étape (E5) de gravure de la deuxième couche diélectrique (D2) de sorte à exposer la première couche diélectrique (D1) entre chaque premier pilier (PI) de la matrice de premiers piliers (PI) selon les diagonales de ladite matrice de premiers piliers (PI) ;
- Une étape (E7) de dépôt d'une première couche conductrice de sorte à combler les ouvertures réalisées lors de l'étape (E5) de gravure de la deuxième couche diélectrique (D2) ;
- une étape (E8) de polissage mécano-chimique de la structure obtenue à l'issue de l'étape précédente de sorte à obtenir une matrice de deuxièmes piliers (PC1) conducteurs (PC1) au niveau des ouvertures réalisées lors de l'étape (E5) de gravure de la deuxième couche diélectrique (D2), l'arrêt du polissage se faisant sur la couche support (SP) de sorte que les deuxièmes piliers (PC1) conducteurs ne sont plus en contact entre eux à l'issue de cette étape (E8) et forment les troisièmes grilles (G3) ;
- Une étape (E9) de retrait sélectif de la deuxième couche diélectrique (D2) de sorte à ne conserver sur la première couche diélectrique (D1) que la matrice de premiers piliers (PI) et la matrice de deuxièmes piliers (PC1) conducteurs ;
- Une étape (E10) de dépôt conforme d'une troisième couche diélectrique (D3) sur la matrice de premiers piliers (PI) et la matrice de deuxièmes piliers (PC1) conducteurs, l'épaisseur déposée étant choisie de sorte à combler l'espace entre chaque premier pilier (PI) et les deuxièmes piliers (PC2) conducteurs plus proches voisins dudit premier pilier (PI) ;
- Une étape (E11) de gravure de la troisième couche diélectrique (D3) de sorte à exposer la première couche diélectrique (D1) entre chaque premier pilier (PI) de la matrice de premiers piliers (PI) selon les lignes et les colonnes de ladite matrice de premiers piliers (PI) ;
- Une étape (E12) de dépôt d'une deuxième couche conductrice (C2) de sorte à combler les ouvertures réalisées lors de l'étape (E11) de gravure de la troisième couche diélectrique (D3) ;
- une étape (E13) de polissage mécano-chimique de la structure obtenue à l'issue de l'étape précédente, de sorte à obtenir une matrice de troisièmes piliers (PC2) conducteurs au niveau des ouvertures réalisées lors de l'étape (E11) de gravure de la troisième couche diélectrique (D3), l'arrêt du polissage se faisant sur la couche support (SP) de sorte que les troisièmes piliers (PC2) conducteurs ne sont plus en contact entre eux à l'issue de cette étape (E13) et forment les premières grilles (G1) et les deuxièmes grilles (G2) ;
- Lorsque le matériau de la couche support (SP) est un matériau diélectrique, une étape (E15) de retrait sélectif des premiers piliers (PI) de la pluralité de premiers pilier (PI) de sorte à exposer la première couche diélectrique (D1) au niveau de l'emplacement desdits premiers piliers (PI) ;
- Lorsque le matériau de la couche support est un matériau diélectrique, une étape (E16) de dépôt d'une troisième couche conductrice dans l'espace laissé par les premiers piliers (PI) lors de l'étape de retrait sélectif précédente ;
- Lorsque le matériau de la couche support est un matériau diélectrique, une étape (E17) de polissage mécano-chimique de la structure obtenue à l'issue de l'étape précédente, de sorte à obtenir une matrice de quatrièmes piliers (PC3) conducteurs à l'emplacement des premiers piliers (PI), l'arrêt du polissage se faisant de sorte que les quatrièmes piliers conducteurs ne sont plus connectés entre eux à l'issue de cette étape et forment quatrièmes grilles (G4).

14. Procédé selon la revendication précédente dans lequel le substrat (SB) est un substrat de type SOI et la couche active (CA) est réalisé dans la couche de silicium du substrat (SB).

15. Procédé selon l'une des deux revendications précédentes dans lequel la distance d séparant deux premiers piliers (PI) voisins et la hauteur h des premiers piliers (PI) à l'issue de l'étape (E3) de gravure de la couche support (SP) de sorte à former une matrice de premiers piliers (PI) sont choisis de sorte que h> d/2.
